Europäisches Patentamt

European Patent Office

Office européen des brevets

(11) Publication number: **0 157 040**
**A2**

## EUROPEAN PATENT APPLICATION

(21) Application number: 84307052.5

(22) Date of filing: 15.10.84

(51) Int. Cl.⁴: **C 23 C 16/56**
// G02B1/02

(30) Priority: 27.03.84 JP 59866/83

(43) Date of publication of application: 09.10.85
Bulletin 85/41

(84) Designated Contracting States: DE FR GB

(71) Applicant: SUMITOMO ELECTRIC INDUSTRIES
LIMITED, No. 15, Kitahama 5-chome Higashi-ku,
Osaka-shi Osaka-fu (JP)

(72) Inventor: Kikuchi, Motoji c/o Osaka Works of Sumitomo,
Electric Industries Ltd. 1-3, Shimaya, 1-chome
Konohana-ku Osaka (JP)
Inventor: Shibata Kenichiro c/o Osaka Works of
Sumitomo, Shibata Kenichiro c/o Itomo Works of
Sumitomo, 1-chome Itami-shi Hyogo (JP)

(74) Representative: Bankes, Stephen C. D. et al, Baron &
Warren 18 South End Kensington, London W8 5BU (GB)

(54) Method of producing transparent polycrystalline ZnS body.

(57) The present invention relates to a method of producing a very hard transparent polycrystalline ZnS body which is useful for optical materials for use in infrared instruments. The method of the invention comprises the hot isostatic pressing of a polycrystalline ZnS body, obtained by a chemical vapour deposition method, for 1 hour or more at temperatures higher than 1,050 °C and pressures of 500 atm or more.

## Method of Producing Transparent Polycrystalline
## ZnS Body

The present invention relates to a method of producing a highly hard transparent polycrystalline ZnS body which is useful for optical materials for use in infrared instruments.

The conventional transparent polycrystalline ZnS body has been produced by hot isostatic pressing (hereinafter referred to as HIP) a polycrystalline ZnS body obtained by a chemical vapour deposition method (hereinafter referred to as CVD method) or a hot pressing method for 3 hours or more at temperatures of 700 to 1,050 °C and pressures of 350 to 2,100 atm for example as disclosed in Japanese Patent Laid-Open No.Sho 57-135723.

It is, however, indicated that a polycrystalline ZnS obtained by this method has a disadvantage of low hardness.

Although a polycrystalline ZnS body obtained by a CVD method has high hardness of about 200 prior to HIP, it is not transparent but translucent. Such a translucent polycrystalline ZnS is inferior in optical property.

Heretofore, HIP treatment has been used in order to improve optical characteristics (that is to say give the transparency).

It is made clear that optical characteristics and hardness of a polycrystalline ZnS body are influenced by various factors such as the chemical composition of ZnS, fine pores, a strain in a crystal lattice and stacking faults.

The present inventors found the investigations of HIP method of producing a polycrystalline ZnS body having improved optical characteristics without reducing the hardness of said polycrystalline ZnS body when synthesized by CVD method with respect to the above described points that a polycrystalline ZnS body having improved optical characteristics could be obtained by hot isostatic pressing it for 1 hour or more at temperatures higher than 1,050 °C and pressures of 500 atm or more, and as a result the present invention was achieved.

That is to say, a transparent polycrystalline ZnS body can be obtained with holding its hardness when synthesized by CVD method (200 in knoop hardness) by HIP method under such conditions.

Accordingly, the transmittance for both visible rays and infrared rays can be increased without reducing the hardness.

Furthermore, since the surface hardness is high a polycrystalline body, which is superior in environment-resistance and transparent for visible rays, can be produced.

It is perhaps the reason of the above-mentioned that there are many stacking faults in hot isostatic pressed polycrystalline grains, said stacking faults introduced into said grains when synthesized by CVD method (during the growth of crystals) being held without reducing during HIP if it is carried out under the conditions according to the present invention.

It is a remarkably useful characteristic for infrared optical materials in setting of optical axis and the like that a polycrystalline ZnS body produced by HIP method according to the present invention is transparent.

In addition, according to the present invention, a polycrystalline ZnS grain is grown by HIP treatment but the hardness thereof is not reduced.

It is perhaps the reason of the above-mentioned that there are many stacking faults in a polycrystalline grain without reducing.

In short, the hardness is not dependent upon the grain diameter but dependent upon stacking faults in said grain.

The present invention will be in detail described below with reference to Examples.

Examples
Polycrystalline ZnS bodies were deposited on a graphite substrate from $H_2S$ having the purity of 99.999 % and zinc vapour from metallic zinc having the purity of 99.9999 % by CVD method carried out at a reaction temperature of 750 °C and a furnace pressure of 50 Torr with using Ar gas having the purity of 99.999 % as a carrier gas.

In this case, the growth rate was about 30 micron/hr and polycrystalline ZnS bodies of 5 mm thick were obtained for 160 hours.

The samples having diameters of 25 to 35 mm and a thickness of 4 mm were cut out from the resulting polycrystalline ZnS bodies and both sides of the resulting samples were subjected to an optical polishing. Then, the polished samples were tested on optical characteristics
(spectral characteristics), mechanical characteristics
(knoop hardness) and the like.

Said samples were subjected to HIP treatment under
various kinds of condition and then tested on various
characteristics before and after HIP treatment. The
results are shown in Table 1.

As to the conditions of HIP treatment, a temperature was
varied in a range of 900 to 1,400 °C,a pressure being
varied in a range of 500 to 2,000 atm, and a treatment
time being varied in a range of 1 to 2.5 hours in combination.

The transmittance and absorption edge in Table 1 were
measured by means of a double beam-type spectrophotometer after both sides of samples were subjected
to an optical polishing.

Table 1

| No. | Division | Condition of HIP | | | Transmittance of light | | | | Absorption edge | | Knoop hardness | |
|---|---|---|---|---|---|---|---|---|---|---|---|---|
| | | | | | (0.7 $\mu$m) | | (2.5 $\mu$m) | | | | | |
| | | Temp. (°C) | Pressure (atm) | Hour (H) | Before HIP | After HIP | Before HIP | After HIP | Before HIP | After HIP | Before HIP | After HIP |
| 1 | Comp. ex. | 900 | 2000 | 1 | 8 | 15 | 40 | 41 | 390 | 380 | 195 | 211 |
| 2 | ditto | 950 | 2000 | 1 | 5 | 11 | 29 | 35 | 400 | 390 | 198 | 192 |
| 3 | ditto. | 1050 | 2000 | 1 | 12 | 17 | 31 | 42 | 390 | 385 | 205 | 193 |
| 4 | Example | 1100 | 2000 | 1 | 16 | 74 | 32 | 74 | 390 | 345 | 200 | 204 |
| 5 | ditto | 1070 | 1000 | 2 | 16 | 55 | 33 | 61 | 390 | 365 | 191 | 194 |
| 6 | ditto | 1100 | 1000 | 2.5 | 6 | 71 | 26 | 72 | 400 | 346 | 190 | 198 |
| 7 | ditto | 1130 | 1800 | 1 | 11 | 73 | 30 | 70 | 400 | 348 | 198 | 201 |
| 8 | ditto | 1200 | 1800 | 1. | 9 | 73 | 36 | 73 | 390 | 345 | 187 | 199 |
| 9 | ditto | 1300 | 1800 | 1 | 16 | 72 | 39 | 73 | 380 | 345 | 203 | 209 |
| 10 | ditto | 1100 | 1000 | 1 | 16 | 70 | 42 | 72 | 380 | 347 | 195 | 201 |

| 11 | ditto | 1100 | 500 | 1 | 18 | 69 | 41 | 71 | 380 | 347 | 185 | 198 |
| 12 | ditto | 1100 | 1300 | 2.5 | 17 | 72 | 35 | 73 | 370 | 360 | 192 | 180 |
| 13 | ditto | 1400 | 1800 | 1 | 15 | 71 | 37 | 74 | 370 | 344 | 195 | 207 |
| 14 | ditto | 1070 | 2000 | 1.5 | 16 | 71 | 36 | 74 | 390 | 345 | 204 | 205 |

- 6 -

0157040

It is found from Comparative Examples No. 1 to 3 in Table 1 that with a temperature of HIP treatment of 1,050 °C or less sufficient optical characteristics can not be reached.

It is found from Examples No. 4 to 14 in Table 1 that with temperatures of HIP treatment higher than 1,050 °C the transmittance of light is remarkably increased for both wavelengths of 0.7 microns and 2.5 microns and an absorption edge is shifted toward a short wavelength side by HIP treatment.

In addition, it is found from the transmittance of light and a temperature of HIP treatment in Examples No. 5, 14, in which a temperature of HIP treatment is 1,070 °C, that also a pressure has a remarkable influence upon the transmittance of light.

It is, however, found that in cases where a pressure and a treatment time are held constant, with temperatures of HIP treatment higher than 1,050 °C the transmittance of light is radically increased.

It is perhaps the reason of the above-mentioned that any one of a chemical composition of ZnS, fine pores, a strain in crystal lattice, stacking fault and the like, which have an influence upon the optical characteristics of a polycrystalline ZnS body, is radically changed when a temperature of HIP treatment becomes higher than 1,050 °C.

Summarizing the above-mentioned, with a tmeperature of HIP treatment of 1,050 °C or less the optical characteristics, in particular the transmittance of light near visible rays is not sufficiently increased and with a temperature of HIP treatment higher than 1,050 °C

- 7 -

0157040

the transmittance of visible rays is increased, whereby the setting of an optical axis in an optical system used is very easily carried out.

For example, in cases where the transmittance is 50 % or more, the sufficient setting of optical axis can be achieved since a polycrystalline ZnS body is transparent to such an extent that an adhesion tape is adhered onto frosted glass.

However, with a temperature of HIP treatment over 1,400 °C the crystal grains are greatly grown and the flexural strength thereof is reduced. With a pressure lower than 500 atm the effect of the improvement in optical characteristics is not remarkable.

In addition, with a pressure of 2,000 atm or more the economical effect is insufficient.

As to a treatment time of HIP treatment, the long treatment time of 3 hours or more is not desirable from an economical point of view.

In short, temperatures of 1,050 to 1,400 °C,pressures of 500 to 2,000 atm and 1 to 3 hours are suitable for the conditions of HIP treatment according to the present invention.

A refractive index of ZnS is about 2.2. Provided that a refractive index n of air is 1, the theoretical reflection factor R on one side is expressed by the following equation (1):

$$R = \left\{ (n-1)/(n+1) \right\}^2 \quad \ldots \quad (1)$$

In addition, the transmittance of light of a flat plate is expressed by the following equation (2):

$$\text{Transmittance} = (1 - R)^2 \quad \dots \quad (2)$$

Accordingly, a reflection loss of ZnS is about 26 % and the theoretical transmittance of a flat plate made thereof is about 74 %. consequently, the value of 74 % of the data of transmittance of light shown in Table 1 is identical with the theoretical value and largest.

Furthermore, according to the present invention, a polycrystalline ZnS body obtained by CVD method may be preliminarily enclosed in a pyrex capsule or may be covered with a platinum foil and the like.

It can be found from Table 1 that a polycrystalline ZnS body produced by a method according to the present invention is superior in both hardness and optical characteristics, whereby useful for optical materials for use in infrared instruments.

0157040

## CLAIMS

1. A method of producing a transparent polycrystalline ZnS body, characterized by hot isostatic pressing a polycrystalline ZnS body obtained by a chemical vapour deposition method for 1 hour or more at temperatures higher than 1,050°C and pressures of 500 atm or more.

2. A method according to claim 1, wherein the isostatic pressing temperature is in the range from 1100 to 1400°C.

3. A method according to claim 1 or claim 2, wherein the isostatic pressing is carried out for a period of 1 to 4 hours.